# EUROPÄISCHE PATENTSCHRIFT

(11) **EP 3 447 349 B1**
(45) Veröffentlichungstag und Bekanntmachung des Hinweises auf die Patenterteilung: **12.08.2020**
(21) Anmeldenummer: 18190119.0
(22) Anmeldetag: 22.08.2018
(51) Int. Cl.: F16K 31/126, F16K 37/00, H05F 3/02, G01R 27/20

(54) **STELLVENTIL**
CONTROL VALVE
VANNE DE RÉGULATION

(30) Priorität: 22.08.2017 DE 102017119205
(43) Veröffentlichungstag der Anmeldung: 27.02.2019
(73) Patentinhaber: Samson AG, 60314 Frankfurt (DE)
(72) Erfinder: Mellinger, Christian, 63179 Obertshausen HE Hessen (DE); Kah, Harald, 65611 Brechen HE Hessen (DE)
(74) Vertreter: Puschmann Borchert Bardehle Patentanwälte Partnerschaft mbB

(56) Entgegenhaltungen:
- EP-A1- 0 501 817
- WO-A1-97/39267
- DE-U1- 20 007 204
- JP-A- H04 262 182
- JP-U- S5 617 463

## Beschreibung

Die Erfindung betrifft ein Stellventil zum Einstellen einer Prozessfluidströmung einer prozesstechnischen Anlage.

Statische Aufladungen im oder am Ventil können zur Funkenbildung und somit zu einem kritischen Zustand führen. Daher muss sichergestellt werden, dass der Ventilkörper in jeder Stellung sicher mit der Rohrleitung geerdet ist, obwohl bei einem geöffneten Ventil kein direkter Kontakt über einen metallischen Ventilsitz zum Gehäuse besteht. In der bisherigen Praxis wird zur Überwachung der sicheren Erdung zwischen dem Stellglied und dem Ventilgehäuse der Durchgangwiderstand einmalig bei der Auslieferung des Produkts gemessen. Der ohmsche Widerstand des Durchgangwiderstands darf nicht größer als 10 Ohm sein. Eine Überwachung über die Zeit, d.h. eine Überprüfung des ohmschen Widerstandes der Erdung zwischen den bewegten Ventilteilen und dem Gehäuse findet nicht statt.

Die EP 83105457 betrifft eine elektrostatische Ableitungsvorrichtung für Hähne mit einer sphärischen Oberfläche mit einem Kontaktelement zwischen einem Kugelventil und einer Spindel und einem zweiten Kontaktelement zwischen der Spindel und einer Stopfbuchse, wobei zumindest das Kontaktelement zwischen der Kugel und der Spindel aus zwei in einer Buchse geführten Metallstiften besteht, die mit der Kugel und mit der Spindel mittels einer zwischen den beiden Metallstiften angeordneten Feder in Kontakt stehen, sodass die Feder keinen aggressiven Flüssigkeiten ausgesetzt ist. Diese Anordnung garantiert nur die Ableitung der elektrostatischer Ladung, ist jedoch nicht für den Fall ausgelegt, dass sich der Kontakt zwischen den Teilen, die in der Stromführung beteiligt sind, in der Zeit ändern kann.

In der JP S56 17463 U ist ein Stellventil gemäß dem Oberbegriff des Anspruchs 1 offenbart.

Der Erfindung liegt die Aufgabe zugrunde, einen Stellventil bereitzustellen, bei dem der ohmsche Übergangswiderstand zwischen der Ventilstange und dem geerdeten Gehäuse festgestellt werden kann, um eine statische Aufladung in dem Stellventil und damit eine Explosionsgefahr zu vermeiden.

Die Aufgabe wird durch die kennzeichnenden Merkmale des Anspruchs 1 in Verbindung mit seinen Oberbegriffsmerkmalen gelöst.

Die Unteransprüche bilden vorteilhafte Weiterbildungen der Erfindung.

Bekannter Weise weist das erfindungsgemäße Stellventil zum Einstellen einer Prozessfluidströmung einer prozesstechnischen Anlage ein Ventilgehäuse mit einem Ventilsitz und ein mit einer Ventilstange verbundenes Ventilglied, das mit dem Ventilsitz zum Öffnen und Schließen des Stellventils zusammenwirkt, auf. Die Ventilstange ist mit dem Ventilgehäuse über eine Kontaktierungseinrichtung elektrisch verbunden.

Erfindungsgemäß ist eine Messeinrichtung zur ohmschen Messung des Übergangswiderstandes der Kontaktierungseinrichtung vorgesehen, wobei die Messeinrichtung in einer das Ventilgehäuse mit der Ventilstange verbindenden Messleitung angeordnet ist.

Die Messleitung ist als Leitungspfad zwischen der Ventilstange einerseits und einem geerdeten Bauteil, insbesondere dem geerdeten Ventilgehäuse, oder an einem mit dem Ventilgehäuse verbundenen Bauteil des Stellventils andererseits vorgesehen. Die Messleitung kann so auch über ein oder mehrere mit der Ventilstange in elektrischer Verbindung stehende Bauteile des Stellventils geführt werden.

Bei der Erfindung kann eine ständige Überwachung des Übergangswiderstandes zwischen der Ventilstange und dem, insbesondere ortsfesten, geerdeten, Gehäuse stattfinden, sodass unmittelbar festgestellt werden kann, wenn sich eine Explosionsgefahr ergeben sollte.

Die Kontaktierungseinrichtung wird üblicherweise über die Stopfbuchspackung und / oder indirekt über den Stellantrieb bereitgestellt. Die Kontaktierungseinrichtung kann auch einen Schleifkontakt, beispielsweise in Form eines Federblechs umfassen, der die Ventilstange elektrisch leitend mit dem Gehäuse verbindet.

Eine vorteilhafte Ausgestaltung des erfindungsgemäßen Stellventils ist dadurch gekennzeichnet, dass die Messleitung von der Ventilstange über die Messeinrichtung und über ein mit dem Ventilgehäuse verbundenes Joch oder einen mit dem Ventilgehäuse verbundenen Stellantrieb zu dem Ventilgehäuse verläuft. Die Messleitung kann so bedarfsgemäß gewählt werden.

Die Messleitung kann bevorzugt Bauteile eines an der Ventilstange angeschlossenen Stellungsreglers umfassen. So können leitend an der Ventilstange befestigte Teile eines mechanischen Hubabgriffs eines Stellungsreglers einen Teil der Messleitung bilden. Der Hubabgriff kann einen Hebelarm umfassen, der über eine sogenannte leitend ausgebildete Hubrolle die Ventilstange, insbesondere über ein Hubabgriffsteil, kontaktiert. Der Hebelarm ist drehfest und elektrisch leitend mit einer Welle verbunden, wobei die Welle in einem entsprechenden Lager des Stellungsreglers drehbar gelagert ist. Die Messleitung führt von der Ventilstange über die Hubrolle, den Hebelarm über die Welle, wo sie über Schleifkontakte über die Messeinrichtung mit dem Gehäuse des Stellventils verbunden ist.

In vorteilhafter Weise wird ein Teil der Messleitung so durch ohnehin vorhandene Bauelemente gebildet, so dass keine zusätzliche Kontaktierung der axial bewegten Ventilstange notwendig ist.

Bevorzugt können das Ventilgehäuse und die Messleitung über "Erde" verbunden sein. Ist das Ventilgehäuse geerdet, kann so die Messleitung physisch an einem beliebigen geerdeten Kontakt am Stellventil enden.

Gemäß einer weiteren Ausgestaltung, kann der Hebelarm über eine Drehfeder federbelastet gegenüber dem Ventilgehäuse, insbesondere gegenüber dem Stellungsreglergehäuse (elektrisch isoliert) gelagert sein. In diesem Fall kann die Messleitung vom Hebelarm über die Drehfeder geführt sein, was eine verschleißbehaftete Kontaktierung der Welle durch einen Schleifkontakt überflüssig macht.
Da der Hubabgriffsteil, der Drehhebel mit der Hubrolle und die Welle des Hubabgriffs Bestandteile des Stellungsreglers sind, kann somit die Messleitung in vorteilhafter Weise mit nur einem zusätzlichen Bauteil, nämlich dem Schleifkontakt bzw. der Drehfeder, verwirklicht werden.

Bevorzugt kann die Messleitung eine Kontaktstelle zur Befestigung einer elektrischen Schaltungsplatine in dem Stellungsregler oder eine Anschlussstelle an der Innenwand des Stellungsreglers umfassen. Diese Stellen sind besonders geeignet, weil sie im Innern des Stellungsreglers liegen, somit geschützt sind, und der weiteren Ausgestaltung des Stellventils nicht im Wege stehen.

Insbesondere umfasst die Messeinrichtung zur Messung des ohmschen Übergangswiderstandes einen ersten Transformator und einen zweiten Transformator. Die Messleitung ist derart gestaltet, dass sie eine Sekundärwicklung des ersten Transformators und eine Primärwicklung des zweiten Transformators bildet. Ein von einer Impulsquelle auf den ersten Transformator ausgeprägter Spannungsimpuls liefert so an dem zweiten Transformator einen von dem Widerstand, der durch die Kontaktierungseinrichtung und der Messleitung gebildeten Schleife, insbesondere Erdschleife, abhängigen Messwert. Daher kann in vorteilhafter Weise eine an sich bekannte Messschaltung verwendet werden, um den Übergangswiderstand zwischen der Ventilstange und dem Ventilgehäuse bei dem erfindungsgemäßen Ventil zu überwachen, wobei derartige Messschaltungen aus der EP 2 249 170 A1 bekannt sind.

Bei einem Stellventil, bei dem die Kontaktierungseinrichtung ein elektrisch leitendes Masseband umfasst, das die Ventilstange mit dem Joch oder dem Ventilgehäuse verbindet, ist vorteilhaft, wenn das Stellventil eine Messeinrichtung der vorstehend beschriebenen Art umfasst, weil dadurch auch ein Bruch des Massebandes von der Messeinrichtung erfasst wird.

Eine weitere vorteilhafte Ausgestaltung des erfindungsgemäßen Stellventils ist dadurch gekennzeichnet, dass die Messeinrichtung zur Messung des ohmschen Übergangswiderstandes eine Auswertungseinrichtung umfasst, die konfiguriert ist, einen Messwert des Widerstandes der Erdschleife zu berechnen und über eine Anzeigeeinrichtung auszugeben. Die Messwerte des Übergangswiderstands können daher in vorteilhafter Weise zeitnah verarbeitet und angezeigt werden.

Bevorzugt kann die Messeinrichtung in den Stellungsregler integriert sein.

Eine weitere vorteilhafte Ausgestaltung des erfindungsgemäßen Stellventils ist dadurch gekennzeichnet, dass eine Anzeigevorrichtung zum Anzeigen der Messwerte direkt an dem Stellungsregler vorgesehen ist, sodass die Bedienungsperson direkt am Stellventil feststellen kann, ob es noch Funktionsanforderungen bezüglich des Übergangswiderstandes entspricht.

Eine weitere vorteilhafte Ausgestaltung des erfindungsgemäßen Stellventils ist dadurch gekennzeichnet, dass in der Auswertungseinrichtung eine Schaltschwelle definiert ist, und dass die Auswertungseinrichtung konfiguriert ist, bei Überschreiten der Schaltschwelle ein Alarmsignal abzugeben, insbesondere anzuzeigen und/oder zu versenden, sodass ein kritischer Zustand des Übergangswiderstandes des Stellventils auch durch einen Alarm angezeigt und/oder an eine entfernt liegende Leitstelle übertragen werden kann.

Die Auswertungseinrichtung kann in vorteilhafter Weise so konfiguriert sein, dass die Messwerte an eine (entfernte) Auswertestation oder eine Leitwarte über ein Bussystem oder über eine drahtlose Verbindung übertragen werden kann.

Weitere Vorteile, Merkmale und Anwendungsmöglichkeiten der vorliegenden Erfindung ergeben sich aus der nachfolgenden Beschreibung in Verbindung mit den in den Zeichnungen dargestellten Ausführungsbeispielen.
- Fig. 1: eine Seitenansicht eines erfindungsgemäßen Stellventils nach einem ersten Ausführungsbeispiel der Erfindung;
- Fig. 2: eine Detailansicht eines Bereichs des erfindungsgemäßen Stellventils nach einem zweiten Ausführungsbeispiel, wobei der Bereich des Stellventils dargestellt ist, in dem die Kontaktierung zu der Stellstange erfolgt;
- Fig. 3: eine Detailansicht eines Bereichs des erfindungsgemäßen Stellventils nach einem dritten Ausführungsbeispiel, wobei der Bereich des Stellventils dargestellt ist, in dem die Kontaktierung zu der Stellstange erfolgt;
- Fig. 4: ein Schaltungsdiagramm einer Mess- und Auswertungsschaltung, die bei dem erfindungsgemäßen Stellventil angewendet wird.

Das in den Figuren gezeigte Stellventil 2 umfasst einen Stellantrieb 4 und ein über ein Joch 6 mit dem Stellantrieb 4 verbundenen Ventilgehäuse 8 mit einem Einlass 10 und einem Auslass 12 und einem Ventilsitz 14, der durch ein Ventilglied 16 zu verschließen oder zu öffnen ist, und der durch eine mit dem Ventilglied 16 und dem Stellantrieb 4 verbundenen Ventilstange 18 betätigt wird. Die Ventilstange 18 ist dazu mit einem Membran-Arbeitsorgan 20 des Stellantriebs 4 verbunden. Das Stellventil 2 wird in an sich bekannter Weise durch einen Stellungsregler 22 vervollständigt.

Bei derartigen Stellventilen ist die Ventilstange 18 mit dem Ventilgehäuse 8 über eine Kontaktierungseinrichtung 42 elektrische verbunden. Erfindungsgemäß findet bei der Erfindung eine ständige Überwachung des Übergangswiderstandes der elektrischen Kontaktierungseinrichtung 42 über eine Messung des Übergangswiderstandes zwischen der Ventilstange 18 und dem geerdeten Gehäuse 8 statt.

Eine Messleitung 24 ist als Leitungspfad zwischen der Ventilstange 18 oder einem mit der Ventilstange 18 in elektrischer Verbindung stehenden Bauteil des Stellventils 2 einerseits und dem geerdeten Ventilgehäuse 8 oder an einem mit dem Ventilgehäuse verbundenen Bauteil des Stellventils 2 andererseits vorgesehen.

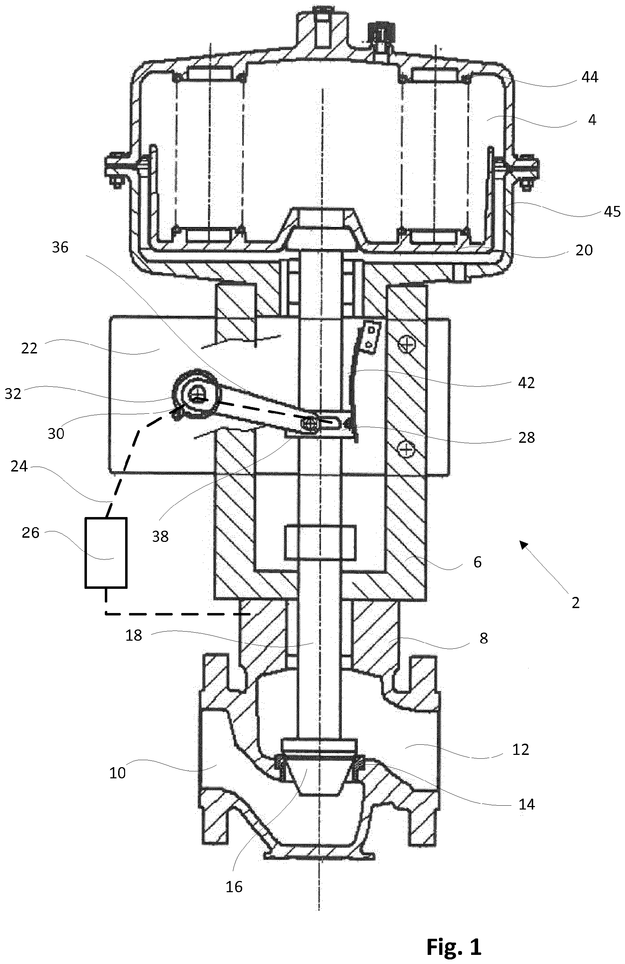

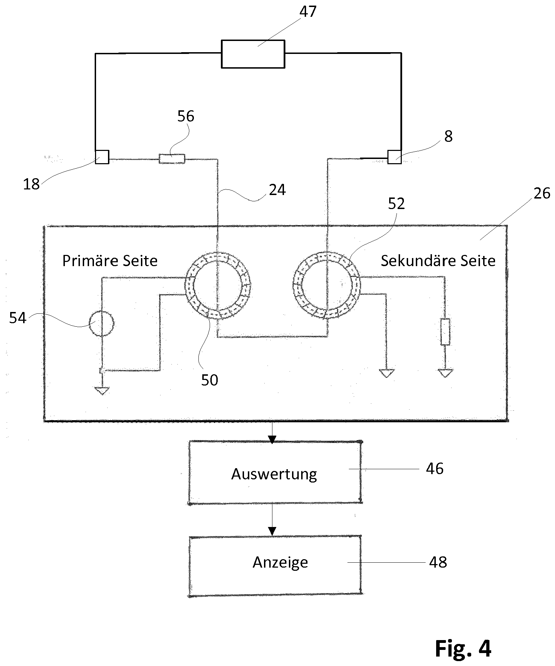

Gemäß Fig. 1 bzw. Fig.4 verläuft die gestrichelt dargestellte Messleitung 24 von der Ventilstange 18 über eine schematisch dargestellte Messeinrichtung 26 zu dem mit dem Ventilgehäuse 8 verbundenen Stellantrieb 4. Insbesondere verläuft die Messleitung 24 über den Hubabgriffsteil 28 des Stellungsreglers 22 an der Ventilstange 18, die Messeinrichtung 26 zu dem fest mit dem Stellantrieb 4 verbundenen Stellungsregler 22. Alternative kann die Messleitung 24 zu dem mit dem Ventilgehäuse 8 verbundenen Joch 6 verlaufen.

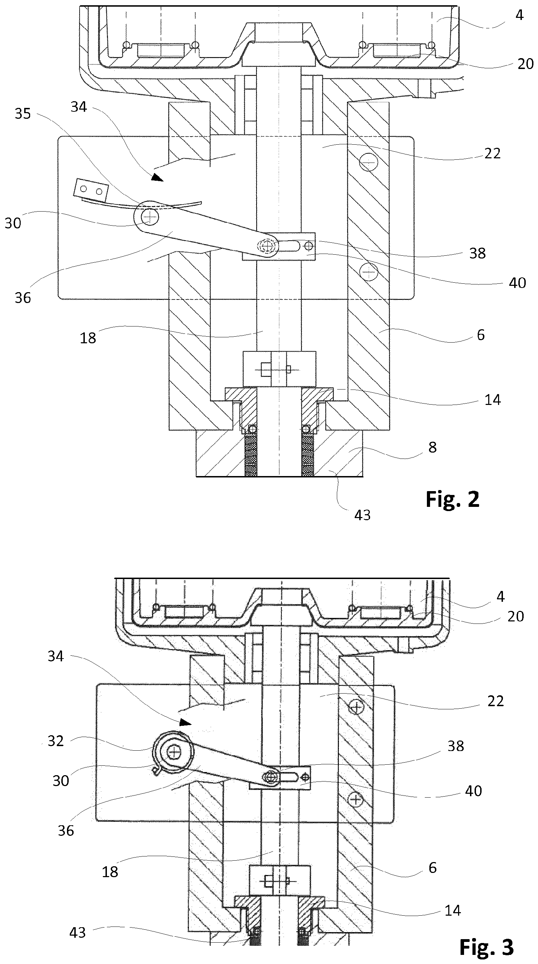

Gemäß Fig. 2 führt die Messleitung 24 (Fig. 4) von der Ventilstange 18 über einen Hubabgriffsteil 28 eines Stellungsreglers 22 an der Ventilstange 18, einen Drehhebel 36 des Stellungsreglers 22, der über eine Hubrolle 38 mit einem Hubabgriffsteil 28 an der Ventilstange 18 verbunden ist, eine durch den Stellungsregler 22 geführte Welle 30 des Hubabgriffs 34, einen Schleifkontakt 35, der an der Welle 30 angreift, die Messeinrichtung 26 und den fest mit dem Stellantrieb 4 verbundenen Stellungsregler 22 zu dem Ventilgehäuse 8. Die Messeinrichtung ist insbesondere an der Innenwand des Stellungsreglers 22 oder an einer Kontaktstelle zur Befestigung einer elektrischen Schaltungsplatine (nicht gezeigt) in dem Stellungsregler 22 angeschlossen.

Gemäß Fig. 3 führt die Messleitung 24 (Fig. 4) von der Ventilstange 18 über den Hubabgriffsteil 28 eines Stellungsreglers 22 an der Ventilstange 18, den Drehhebel 36 des Stellungsreglers 22, der über die Hubrolle 38 mit dem Hubabgriffsteil 28 an der Ventilstange 18 verbunden ist, die durch den Stellungsregler 22 geführte Welle 30 des Hubabgriffs 34, eine Drehfeder 32, die sich um die durch den Stellungsregler 22 geführte Welle 30 des Hubabgriffs erstreckt, die Messeinrichtung 26, und den fest mit dem Stellantrieb 4 verbundenen Stellungsregler 22 zu dem Ventilgehäuse 8 verläuft.

Bei den vorstehend beschriebenen erfindungsgemäßen Stellventilen 2 sind der Hubangriffsteil 28, die Hubrolle 38, der Drehhebel 36, die Welle 30 und der Schleifkontakt 35 bzw. die Drehfeder 32 aus einem elektrisch leitenden Material und gegenüber dem Stellungsregler isoliert und über die isolierte Messeinrichtung 26 mit dem Stellantrieb 22 bzw. dem Ventilgehäuse 8 verbunden. Zwischen der Ventilstange 18 und dem Schleifkontakt 35 oder der Drehfeder 32 addiert sich zwar ein zusätzlicher Übergangswiderstand, die Einrichtung ist aber sicher, wenn der gesamte Übergangswiderstand kleiner als 10 Ohm ist.

Die Kontaktstellen an dem Gehäuse des Stellungsreglers 22, an dem Joch 6 oder an dem Stellantrieb 4 oder dem Ventilgehäuse 8 selbst sind auf einen geringen Übergangswiderstand ausgelegt. Die Verbindung kann entweder über blanke Stellen an den Befestigungen oder über eine zusätzliche Erdungsleitung erfolgen.

Die vorstehend beschriebene Messeinrichtung 26 bei dem erfindungsgemäßen Stellventil kann auch bei einem Stellventil, das in an sich bekannter Weise als Kontaktierungseinrichtung ein elektrisch leitendes Masseband (nicht gezeigt) aufweist, das die Ventilstange 18 mit dem Joch 6 oder dem Ventilgehäuse 8 verbindet, angewendet werden, wobei ein Bruch des Massebandes von der Messeinrichtung 26 erfasst wird.

Bei den oben beschriebenen erfindungsgemäßen Stellventilen 2 kann die Kontaktierungseinrichtung zwischen der Ventilstange 18 und dem Ventilgehäuse 8 einen Schleifkontakt 42 aufweisen, der an einem mit der Ventilstange 18 verbundenen Bauteil, beispielsweise dem Hubabgriffsteil 28, angreift, und mit dem Ventilgehäuse 8 verbunden ist, wie in Fig. 1 gezeigt ist. Die Kontaktierungseinrichtung kann auch eine elektrisch leitende Stopfbuchse 43 zwischen der Ventilstange 18 und dem Ventilgehäuse 8 aufweisen, wie in den Figuren 2 und 3 gezeigt ist. Schließlich kann der elektrische Kontakt zwischen der Ventilstange 18 und dem Ventilgehäuse 8 auch den mit der Ventilstange verbundenen Ventilteller 20, eine mit dem Ventilteller 20 verbundene Stellfeder 44 des Stellantriebs 4 und ein mit der Stellfeder 44 in Kontakt stehenden Stellantriebsgehäuse 45 aufweisen.

Wie in Fig. 4 gezeigt ist, ist zur Messung des ohmschen Übergangswiderstandes, der durch den Widerstand 47 in Fig. 4 dargestellt ist, die Messeinrichtung 26 in der Messleitung 24 angeordnet. Die Messeinrichtung 26 ist mit einer Auswertungseinrichtung 46, in der ein Messwert des Übergangswiderstandes der Kontaktierungseinrichtung berechnet wird, und mit einer Anzeigeeinrichtung 48 verbunden, die zum Anzeigen der Messwerte direkt an dem Stellungsregler 22 vorgesehen ist.

Gemäß Fig. 4 umfasst die Messeinrichtung 26 einen ersten Transformator 50 und einen zweiten Transformator 52, wobei aus der Messleitung 24 und der Kontaktierungseinrichtung eine Erdschleife gebildet wird, deren Widerstand sich aus dem Leitungswiderstand 56 der Messleitung 24 und dem Übergangswiderstand der Kontaktierungseinrichtung zusammensetzt und die durch den ersten Transformators 50 und den zweiten Transformators 52 verläuft.

Ein durch eine Impulsquelle 54 auf den ersten Transformator 50 aufgeprägter Spannungsimpuls liefert an dem zweiten Transformator 52 einen Messwert abhängig von dem Widerstand der Erdschleife. Auf die zu überwachende lokale elektrische Verbindung zwischen der Ventilstange 18 und dem Ventilgehäuse 8 wird somit transformatorisch ein Spannungsimpuls eingeprägt. Die Verschaltung der Transformatoren ist an sich bekannt, siehe EP 2 249 170 A1.

Der benötigte Spannungsimpuls liegt bei einer Länge von etwa 1µs, und die Primärspannung ist klein, d. h. typischerweise kleiner als 3V. Die für einen Impuls benötigte Energie ist dabei kleiner als 2 nJ (Messwert). Selbst bei einer Messrate von 500/s bleibt die mittlere Leistungsaufnahme für die Bereitstellung des Impulses unter 1µW (= 2 nJ/2 ms). In der Erdschleife wird dabei nur eine sehr kleine Spannung induziert, die typischerweise kleiner als 100 mV ist. Dadurch ist eine Zündgefahr bei offener Messleitung 24 bzw. Erdschleife ausgeschlossen.

In der Erdschleife fließt ein Impulsstrom von beispielsweise 100 mV/10 Ohm = 10 mA. Dieser Impulsstrom wird mit dem zweiten Transformator detektiert. Da die induzierte Spannung nur von der Windungszahl der Primärwicklung abhängt ist der Ausgang direkt abhängig von dem Widerstand der Erdschleife.

An der Auswertungseinrichtung 46 ist eine Schaltschwelle, beispielsweise 10 Ohm definiert, wobei, wenn der Übergangswiderstand größer wird als die Schaltschwelle, ein Alarmsignal abgegeben und angezeigt und/oder versandt wird. Die Messwerte werden somit an eine Anzeigeeinrichtung 48, eine Auswertestation oder eine Leitwarte über eine Busleitung (beispielsweise Hart, Profibus, CAN, Ethernet oder dergleichen) oder über eine drahtlose Verbindung (beispielsweise Wireless Hart, Bluetooth, NC, WIFI, RFID oder dergleichen) übertragen.

### Bezugszeichenliste

- 2: Stellventil
- 4: Stellantrieb
- 6: Joch
- 8: Ventilgehäuse
- 10: Einlass
- 12: Auslass
- 14: Ventilsitz
- 16: Ventilglied
- 18: Ventilstange
- 20: Membran-Arbeitsorgan
- 22: Stellungsregler
- 24: Messleitung
- 26: Messeinrichtung
- 28: Hubabgriffsteil
- 30: Welle
- 32: Drehfeder
- 34: Hubabgriff
- 35: Schleifkontakt
- 36: Drehhebel
- 38: Hubrolle
- 42: Schleifkontakt
- 43: Stopfbuchse
- 44: Stellfeder
- 45: Ventilantriebsgehäuse
- 46: Auswertungseinrichtung
- 47: Übergangswiderstand
- 48: Anzeigeeinrichtung
- 50: erster Transformator
- 52: zweiter Transformator
- 54: Impulsquelle
- 56: Leitungswiderstand

## Patentansprüche

1. Stellventil zum Einstellen einer Prozessfluidströmung einer prozesstechnischen Anlage, umfassend ein Ventilgehäuse (8) mit einem Ventilsitz (14) und ein mit einer Ventilstange (18) verbundenen Ventilglied (16), das mit dem Ventilsitz (14) zum Öffnen und Schließen des Stellventils (2) zusammenwirkt, wobei die Ventilstange (18) mit dem Ventilgehäuse (8) über eine Kontaktierungseinrichtung (42, 43, 45) elektrisch verbunden ist, **dadurch gekennzeichnet, dass** eine Messeinrichtung (26) zur ohmschen Messung des Übergangswiderstandes der Kontaktierungseinrichtung (42, 43, 45) vorgesehen ist, und dass die Messeinrichtung (26) in einer das Ventilgehäuse (8) mit der Ventilstange (18) verbindenden Messleitung (24) angeordnet ist.

2. Stellventil nach Anspruch 1, **dadurch gekennzeichnet, dass** die Messleitung (24) von der Ventilstange (18) über die Messeinrichtung (26) und ein mit dem Ventilgehäuse (8) verbundenes Joch (6) oder einen mit dem Ventilgehäuse (8) verbundenen Stellantrieb (4) zu dem Ventilgehäuse (8) verläuft.

3. Stellventil nach Anspruch 1 oder 2, **dadurch gekennzeichnet, dass** die Messleitung (24) von der Ventilstange (18) über einen Hubabgriffsteil (28) eines Stellungsreglers (22) an der Ventilstange (18), einen Drehhebel (36) des Stellungsreglers (22), der über eine Hubrolle (38) mit einem Hubabgriffsteil (28) an der Ventilstange (18) verbunden ist, eine durch den Stellungsregler (22) geführte Welle (30) des Hubabgriffs (34), einen Schleifkontakt (35), der an der Welle (30) angreift, die Messeinrichtung (26), und den fest mit dem Stellantrieb (4) verbundenen Stellungsregler (22) zu dem Ventilgehäuse (8) verläuft.

4. Stellventil nach Anspruch 1 oder 2, **dadurch gekennzeichnet, dass** die Messleitung (24) von der Ventilstange (18) über einen Hubabgriffsteil (28) eines Stellungsreglers (22) an der Ventilstange (18), einen Drehhebel (36) des Stellungsreglers (22), der über eine Hubrolle (38) mit einem Hubabgriffsteil (28) an der Ventilstange (18) verbunden ist, eine durch den Stellungsregler (22) geführte Welle (30) des Hubabgriffs (34), eine elektrisch leitende Drehfeder (32), die sich um eine durch den Stellungsregler (22) geführten elektrisch leitende Welle (30) des Hubabgriffs (34) erstreckt, die Messeinrichtung (26) und den fest mit dem Stellantrieb (4) verbundenen Stellungsregler (22) zu dem Ventilgehäuse (8) verläuft.

5. Stellventil nach Anspruch 3 oder 4, **dadurch gekennzeichnet, dass** die Messleitung (24) eine Kontaktstelle zur Befestigung einer elektrischen Schaltungsplatine in dem Stellungsregler (22) oder eine Kontaktstelle an der Innenwand des Stellungsreglers (22) umfasst.

6. Stellventil nach einem der vorhergehenden Ansprüche, **dadurch gekennzeichnet, dass** die Messeinrichtung (26) zur Messung des ohmschen Übergangswiderstandes einen ersten Transformator (50) und einen zweiten Transformator (52) umfasst, wobei die Messleitung (24) eine Sekundärwicklung des ersten Transformators (50) und eine Primärwicklung des zweiten Transformators (52) bildet, wobei ein von einer Impulsquelle (54) auf den ersten Transformator (50) aufgeprägter Spannungsimpuls an der Sekundärwicklung des zweiten Transformator (52) einen von dem Widerstand der durch die Kontaktierungseinrichtung (42, 43, 45) und die Messleitung (24) gebildeten Erdschleife abhängigen Messwert liefert.

7. Stellventil, bei dem die Kontaktierungseinrichtung ein elektrisch leitendes Masseband umfasst, das die Ventilstange (18) mit dem Joch (6) oder dem Ventilgehäuse (8) verbindet, **dadurch gekennzeichnet, dass** das Stellventil eine Messeinrichtung (26) nach einem der vorhergehenden Ansprüche umfasst.

8. Stellventil nach einem der vorhergehenden Ansprüche, **dadurch gekennzeichnet, dass** an die Messeinrichtung (26) zur Messung des ohmschen Übergangswiderstandes eine Auswertungseinrichtung (46) angeschlossen ist, die konfiguriert ist, einen Messwert des Widerstandes der Erdschleife zu berechnen und über eine Anzeigeeinrichtung (48) auszugeben.

9. Stellventil nach Anspruch 8, **dadurch gekennzeichnet, dass** eine Anzeigevorrichtung (48) zum Anzeigen der Messwerte direkt an dem Stellungsregler (22) vorgesehen ist.

10. Stellventil nach Anspruch 8 oder 9, **dadurch gekennzeichnet, dass** in der Auswertungseinrichtung (46) eine Schaltschwelle von beispielsweise 10 Ohm definiert ist, und dass die Auswertungseinrichtung (46) konfiguriert ist, bei Überschreiten des Schaltschwelle ein Alarmsignal zu abzugeben, insbesondere anzuzeigen und/oder zu versenden.

11. Stellventil nach einem der Ansprüche 8 bis 10, **dadurch gekennzeichnet, dass** die Auswertungseinrichtung (46) konfiguriert ist, die Messwerte an eine Auswertestation oder eine Leitwarte über ein Bussystem oder über eine drahtlose Verbindung zu übertragen.

## Claims

1. Control valve for adjusting a process fluid flow of a process plant, comprising a valve housing (8) with a valve seat (14) and a valve member (16) connected to a valve rod (18), which valve member (16) cooperates with the valve seat (14) for opening and closing the control valve (2), with said valve rod (18) being electrically connected to said valve housing (8) via a contact device (42, 43, 45), **characterized in that** a measuring device (26) is provided for the ohmic measurement of the contact resistance of the contact device (42, 43, 45), and **in that** the measuring device (26) is arranged in a measuring line (24) that connects the valve housing (8) to the valve rod (18).

2. Control valve according to claim 1, **characterized in that** the measuring line (24) extends from the valve rod (18) to the valve housing (8) via said measuring device (26) and a yoke (6) connected to said valve housing (8) or via an actuator (4) connected to said valve housing (8).

3. Control valve according to one of claims 1 and 2, **characterized in that** from the valve rod (18), the measuring line (24) extends to the valve housing (8) via a stroke sensing member (28) of a positioner (22) on the valve rod (18), a rotary lever (36) of the positioner (22) which lever is connected to a stroke sensing member (28) on the valve rod (18) via a lifting roller (38), a shaft (30) of the stroke sensing means (34) that extends through the positioner (22), a sliding contact (35) which engages on the shaft (30), the measuring device (26) and the positioner (22) that is firmly connected to the actuator (4).

4. Control valve according to one of claims 1 and 2, **characterized in that** from the valve rod (18), the measuring line (24) extends to the valve housing (8) via a stroke sensing member (28) of a positioner (22) on the valve rod (18), a rotary lever (36) of the positioner (22), which lever is connected to a stroke sensing member (28) on the valve rod (18) via a lifting roller (38), a shaft (30) of the stroke sensing means (34) that extends through the positioner (22), an electrically conductive torsion spring (32) which extends around an electrically conductive shaft (30) of the stroke sensing means (34) that extends through the positioner (22), the measuring device (26) and the positioner (22) that is firmly connected to the actuator (4).

5. Control valve according to any one of claims 3 and 4, **characterized in that** the measuring line (24) comprises a contact point for mounting an electrical circuit board in the positioner (22), or a contact point on the inner wall of the positioner (22).

6. Control valve according to any one of the preceding claims, **characterized in that** the measuring device (26) for measuring the ohmic contact resistance comprises a first transformer (50) and a second transformer (52), with said measuring line (24) forming a secondary winding of said first transformer (50) and a primary winding of said second transformer (52), wherein a voltage pulse impressed on said first transformer (50) by a pulse source (54) results in a measured value obtained at the secondary winding of said second transformer (52), which measured value is dependent on the resistance of the ground loop formed by said contact device (42, 43, 45) and said measuring line (24).

7. Control valve in which the contact device comprises an electrically conductive ground strap which connects the valve rod (18) to the yoke (6) or to the valve housing (8), **characterized in that** the control valve comprises a measuring device (26) according to any one of the preceding claims.

8. Control valve according to any one of the preceding claims, **characterized in that** an evaluation device (46) is connected to said measuring device (26) for measuring the ohmic contact resistance, which measuring device is adapted to calculate a measured value of the resistance of the ground loop and to output said value on a display device (48).

9. Control valve according to claim 8, **characterized in that** a display device (48) for displaying the measured values is provided directly on the positioner (22).

10. Control valve according to one of claims 8 and 9, **characterized in that** a switching threshold of 10 ohms, for example, is defined in said evaluation device (46), and **in that** said evaluation device (46) is configured to emit, in particular to display and/or to send, an alarm signal if the switching threshold is exceeded.

11. Control valve according to any one of claims 8 to 10, **characterized in that** said evaluation device (46) is configured to transmit the measured values to an evaluation station or a control room via a bus system or via a wireless connection.

## Revendications

1. Vanne de régulation destinée à réguler un écoulement de fluide de processus d'une installation de procédé, comprenant un logement de vanne (8) avec un siège de vanne (14) et un élément de vanne (16) relié à une tige de vanne (18), lequel coopère avec le siège de vanne (14) pour ouvrir et fermer la vanne de régulation (2), dans laquelle la tige de vanne (18) est électriquement reliée au logement de vanne (8) via un dispositif de mise en contact (42, 43, 45), **caractérisée en ce qu'un** dispositif de mesure (26) est prévu pour un mesurage ohmique de la résistance de passage du dispositif de mise en contact (42, 43, 45), et **en ce que** le dispositif de mesure (26) est agencé dans une conduite de mesure (24) reliant le logement de vanne (8) à la tige de vanne (18).

2. Vanne de régulation selon la revendication 1, **caractérisée en ce que** la conduite de mesure (24) s'étend depuis la tige de vanne (18), via le dispositif de mesure (26) et une culasse (6) reliée au logement de vanne (8) ou un entraînement de réglage (4) relié au logement de vanne (8), jusqu'au logement de vanne (8).

3. Vanne de régulation selon la revendication 1 ou 2, **caractérisée en ce que** la conduite de mesure (24) s'étend depuis la tige de vanne (18), via une pièce de détection de course (28) d'un régulateur de position (22) au niveau de la tige de vanne (18), un levier rotatif (36) du régulateur de position (22) qui est relié à une pièce de détection de course (28) au niveau de la tige de vanne (18) via un rouleau de course (38), un arbre (30) de la détection de course (34) guidé par le régulateur de position (22), un contact glissant (35) qui vient en prise au niveau de l'arbre (30), le dispositif de mesure (26) et le régulateur de position (22) fixement relié à l'entraînement de réglage (4), jusqu'au logement de vanne (8).

4. Vanne de régulation selon la revendication 1 ou 2, **caractérisée en ce que** la conduite de mesure (24) s'étend depuis la tige de vanne (18), via une pièce de détection de course (28) d'un régulateur de position (22) au niveau de la tige de vanne (18), un levier rotatif (36) du régulateur de position (22) qui est relié à une pièce de détection de course (28) au niveau de la tige de vanne (18) via un rouleau de course (38), un arbre (30) de la détection de course (34) guidé par le régulateur de position (22), un ressort rotatif (32) électriquement conducteur qui s'étend autour d'un arbre (30) de la détection de course (34) électriquement conducteur et guidé par le régulateur de position (22), le dispositif de mesure (26) et le régulateur de position (22) fixement relié à l'entraînement de réglage (4), jusqu'au logement de vanne (8).

5. Vanne de régulation selon la revendication 3 ou 4, **caractérisée en ce que** la conduite de mesure (24) comprend un point de contact pour consolider une plaque de circuits imprimés électrique dans le régulateur de position (22) ou un point de contact au niveau de la paroi intérieure du régulateur de position (22).

6. Vanne de régulation selon l'une des revendications précédentes, **caractérisée en ce que** le dispositif de mesure (26) pour le mesurage de la résistance de passage ohmique comprend un premier transformateur (50) et un second transformateur (52), dans laquelle la conduite de mesure (24) forme un enroulement secondaire du premier transformateur (50) et un enroulement primaire du second transformateur (52), dans laquelle une impulsion de tension transmise vers le premier transformateur (50) par une source d'impulsions (54) livre, vers l'enroulement secondaire du second transformateur (52), une valeur mesurée dépendante de la résistance du circuit de terre formé par le dispositif de mise en contact (42, 43, 45) et la conduite de mesure (24).

7. Vanne de régulation dans laquelle le dispositif de mise en contact comprend un ruban de masse électriquement conducteur qui relie la tige de vanne (18) à la culasse (6) ou au logement de vanne (8), **caractérisée en ce que** la vanne de régulation comprend un dispositif de mesure (26) selon l'une des revendications précédentes.

8. Vanne de régulation selon l'une des revendications précédentes, **caractérisée en ce qu'au** niveau du dispositif de mesure (26) pour le mesurage de la résistance de passage ohmique est raccordé un dispositif d'exploitation (46) qui est configuré pour calculer une valeur mesurée de la résistance du circuit de terre et l'émettre via un dispositif indicateur (48).

9. Vanne de régulation selon la revendication 8, **caractérisée en ce qu'un** dispositif indicateur (48) pour indiquer les valeurs mesurées est prévu directement au niveau du régulateur de position (22).

10. Vanne de régulation selon la revendication 8 ou 9, **caractérisée en ce que** dans le dispositif d'exploitation (46) est défini un seuil de commutation de 10 ohm par exemple, et **en ce que** le dispositif d'exploitation (46) est configuré pour délivrer un signal d'alarme en cas de dépassement du seuil de commutation, en particulier pour l'indiquer et/ou l'émettre.

11. Vanne de régulation selon l'une des revendications 8 à 10, **caractérisée en ce que** le dispositif d'exploitation (46) est configuré pour transmettre les valeurs mesurées vers une station d'exploitation ou un poste de commande via un système de bus ou via une liaison sans fil.
